# EUROPEAN PATENT APPLICATION

(11) **EP 4 632 816 A1**
(43) Date of publication of application: **15.10.2025**
(21) Application number: 25169104.4
(22) Date of filing: 08.04.2025
(51) Int. Cl.: H01L 25/075, H01L 25/16, H10H 20/855, H10H 29/14

(54) **LED DISPLAY APPARATUS**

(30) Priority: 12.04.2024 KR 20240049510
(71) Applicant: Samsung Electronics Co., Ltd., Suwon-si, Gyeonggi-do 16677 (KR)
(72) Inventor: CHOI, Punjae, Suwon-si, Gyeonggi-do 16677 (KR); YOON, Sukho, Suwon-si, Gyeonggi-do 16677 (KR); LIM, Jonghoon, Suwon-si, Gyeonggi-do 16677 (KR)
(74) Representative: Kuhnen & Wacker Patent- und Rechtsanwaltsbüro PartG mbB

(57) **Abstract**

A display apparatus includes a circuit board (200) including a driving circuit, a pixel array on the circuit board (200) and including unit pixels (PX), each of the unit pixels (PX) including a plurality of subpixels (SP1, SP2, SP3), and a plurality of microlenses (180R, 180G, 180B) respectively on the plurality of subpixels (SP1, SP2, SP3), where the pixel array further includes a plurality of light-emitting diode (LED) cells each respectively including a first conductivity-type semiconductor layer (112), an active layer (114R, 114G, 114B), and a second conductivity-type semiconductor layer (116) that are sequentially stacked, a passivation layer (120) on side surfaces and lower surfaces of the plurality of LED cells, a reflective layer (160) on the passivation layer (120), the reflective layer (160) configured to emit light toward upper surfaces of the plurality of LED cells, a gap-fill insulating layer (141) on the side surfaces and lower surfaces of the plurality of LED cells, and a first connection electrode (130) on the gap-fill insulating layer (141), and connected to the first conductivity-type semiconductor layers (112).

## Description

### BACKGROUND

Example embodiments of the disclosure relate to a light-emitting diode (LED) display apparatus.

Semiconductor LEDs have been used not only as light sources for lighting apparatuses, but also as light sources for various electronic products. In particular, LEDs have been widely used as light sources for various display apparatuses such as televisions (TVs), mobile phones, personal computers (PCs), laptop PCs, personal digital assistants (PDAs), and the like.

In related art, display apparatuses may mainly include a display panel including a liquid crystal display (LCD), and a backlight. However, recently, display apparatuses using LEDs as pixels and not requiring a backlight, have been developed. Such display apparatuses may not only be miniaturized, but also may implement a high-brightness display apparatus having excellent light efficiency, as compared to LCDs.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a high-efficiency display apparatus capable of improved light uniformity between subpixels.

Additional aspects will be set forth in part in the description which follows and, in part, will be apparent from the description, or may be learned by practice of the presented embodiments.

According to an aspect of an example embodiment, a display apparatus may include a circuit board including a driving circuit, a pixel array on the circuit board and including unit pixels, each of the unit pixels including a plurality of subpixels, and a plurality of microlenses respectively on the plurality of subpixels, where the pixel array further includes a plurality of light-emitting diode (LED) cells each respectively including a first conductivity-type semiconductor layer, an active layer, and a second conductivity-type semiconductor layer that are sequentially stacked, a passivation layer on side surfaces and lower surfaces of the plurality of LED cells, a reflective layer on the passivation layer, the reflective layer configured to emit light toward upper surfaces of the plurality of LED cells, a gap-fill insulating layer on the side surfaces and lower surfaces of the plurality of LED cells, the gap-fill insulating layer at least partially covering the passivation layer and the reflective layer, a first connection electrode on the gap-fill insulating layer, and connected to the first conductivity-type semiconductor layers, and a second connection electrode on the gap-fill insulating layer, and connected to the second conductivity-type semiconductor layers, where the plurality of LED cells include a first LED cell configured to emit first light, a second LED cell configured to emit second light, and a third LED cell configured to emit third light, a width of the first LED cell is greater than a width of the second LED cell and a width of the third LED cell, the plurality of microlenses include a first microlens on the first LED cell, a second microlens on the second LED cell, and a third microlens on the third LED cell, and a width of the first microlens is greater than a width of the second microlens and a width of the third microlens.

According to an aspect of an example embodiment, a display apparatus may include a circuit board including a driving circuit, a pixel array on the circuit board and including unit pixels, each of the unit pixels including a plurality of subpixels, and a plurality of microlenses respectively on the plurality of subpixels, where the circuit board further includes a device board on which elements for the driving circuit are provided, and a first bonding structure including a lower bonding insulating layer on the device board, and lower bonding electrodes in the lower bonding insulating layer, the lower bonding electrodes connected to the driving circuit, where the pixel array further includes a plurality of LED cells each respectively including a first conductivity-type semiconductor layer, an active layer, and a second conductivity-type semiconductor layer that are sequentially stacked, a passivation layer on side surfaces and lower surfaces of the plurality of LED cells, a reflective layer on the passivation layer, the reflective layer configured to emit light toward upper surfaces of the plurality of LED cells, a gap-fill insulating layer on the side surfaces and the lower surfaces of the plurality of LED cells, the gap-fill insulating layer at least partially covering the passivation layer and the reflective layer, a first connection electrode on the gap-fill insulating layer, and connected to the first conductivity-type semiconductor layers, a second connection electrode on the gap-fill insulating layer, and connected to the second conductivity-type semiconductor layers, and a second bonding structure including an upper bonding insulating layer on a lower surface of the gap-fill insulating layer, the upper bonding insulating layer bonded to the lower bonding insulating layer, and upper bonding electrodes in the lower bonding insulating layer, the upper bonding electrodes connected to the first connection electrode and the second connection electrode, the upper bonding electrodes respectively bonded to the lower bonding electrodes, where the plurality of LED cells include a first LED cell configured to emit first light, a second LED cell configured to emit second light, and a third LED cell configured to emit third light, and a width of the first LED cell is greater than a width of the second LED cell and a width of the third LED cell.

According to an aspect of an example embodiment, a display apparatus may include a circuit board including a driving circuit, a pixel array on the circuit board and including unit pixels, each of the unit pixels including a plurality of subpixels, and a plurality of microlenses respectively on the plurality of subpixels, where the pixel array includes a plurality of LED cells, each of the plurality of LED cells including a first conductivity-type semiconductor layer, an active layer, and a second conductivity-type semiconductor layer that are sequentially stacked, each of the plurality of LED cells include a first LED cell configured to emit red light, a second LED cell configured to emit green light, and a third LED cell configured to emit blue light, a width of the first LED cell is greater than a width of the second LED cell and a width of the third LED cell, the width of the first LED cell is 5 µm or less, a number of quantum well layers of the active layer of the first LED cell is greater than a number of quantum well layers of the active layer of the second LED cell and a number of quantum well layers of the active layer of the third LED cell, the plurality of microlenses include a first microlens on the first LED cell, a second microlens on the second LED cell, and a third microlens on the third LED cell, and a width of the first microlens is greater than a width of the second microlens and a width of the third microlens.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a perspective view of a display apparatus according to one or more embodiments;
FIG. 2 is a partially enlarged plan view of portion "A" of the display apparatus in FIG. 1 according to one or more embodiments;
FIG. 3 is a cross-sectional view of a display apparatus according to one or more embodiments;
FIG. 4 is a partially enlarged cross-sectional view of portion "B1" of the display apparatus in FIG. 3 according to one or more embodiments;
FIGS. 5A and 5B are graphs illustrating outputs of light-emitting diode (LED) cells according to an emission wavelength and a cell size, according to one or more embodiments;
FIG. 6 is a diagram of a driving circuit implemented in a display apparatus according to one or more embodiments;
FIG. 7 is a plan view of a display apparatus according to one or more embodiments;
FIGS. 8A and 8B are cross-sectional views of a display apparatus according to one or more embodiments;
FIG. 9 is a partially enlarged cross-sectional view of portion "B2" of the display apparatus in FIG. 8A according to one or more embodiments;
FIG. 10 is a cross-sectional view of a display apparatus according to an example embodiment of the present inventive concept;
FIGS. 11A to 11E are cross-sectional views of a method of manufacturing of a display apparatus according to one or more embodiments;
FIGS. 12A to 12C are cross-sectional views of a method of manufacturing a display apparatus according to one or more embodiments; and
FIG. 13 is a diagram of an electronic device including a display apparatus according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

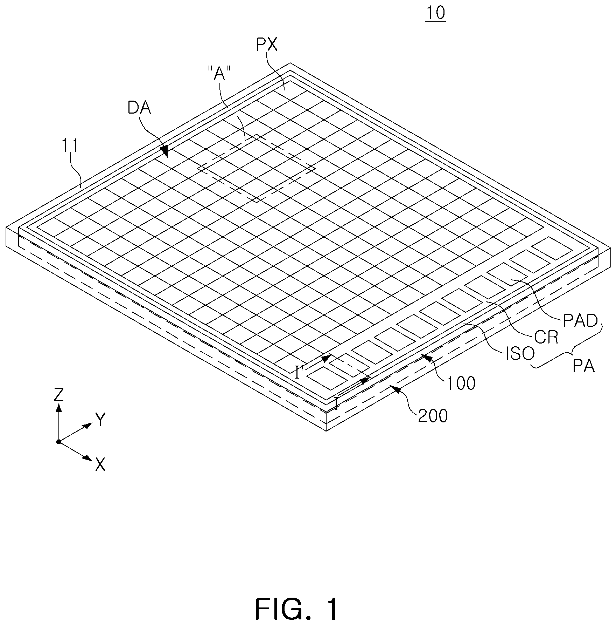

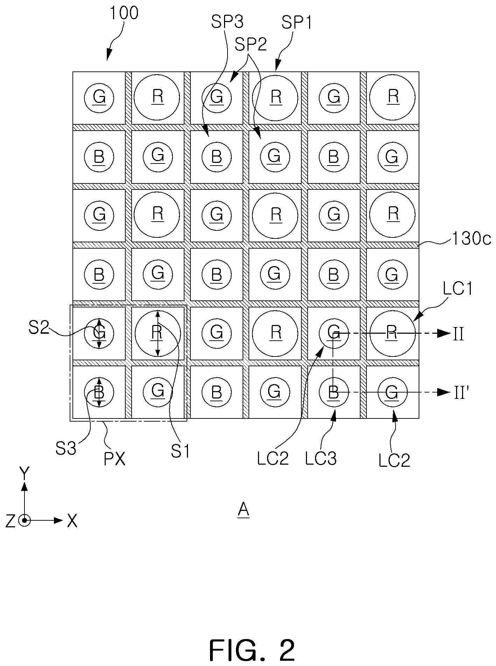

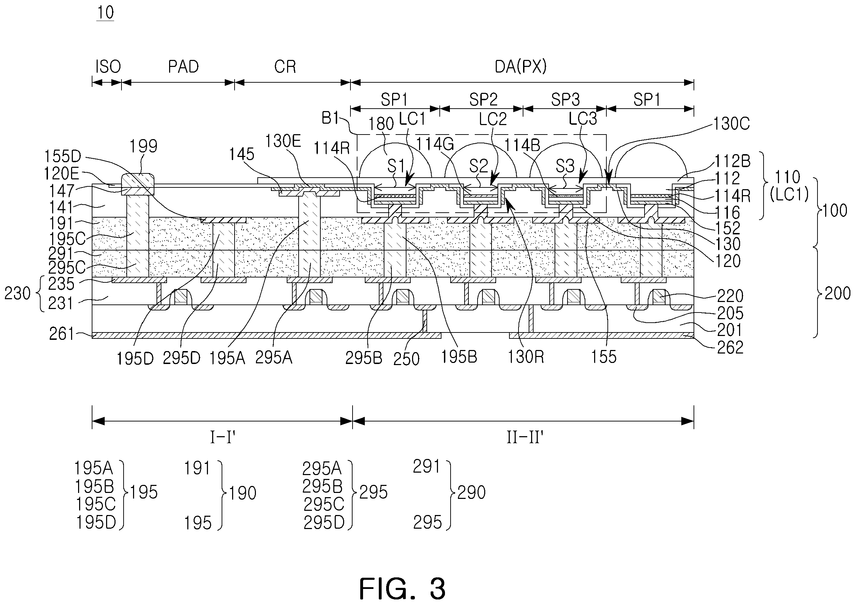

FIG. 1 is a perspective view of a display apparatus according to one or more embodiments. FIG. 2 is a partially enlarged plan view of portion "A" of the display apparatus in FIG. 1 according to one or more embodiments. FIG. 3 is a cross-sectional view of a display apparatus according to one or more embodiments.

Referring to FIGS. 1 to 3, a display apparatus 10 according to one or more embodiments may include a circuit board 200 including driving circuits, and a pixel array 100 disposed on the circuit board 200, the pixel array 100 in which a plurality of pixels PX are arranged. In addition, the display apparatus 10 may further include a frame 11 surrounding the circuit board 200 and the pixel array 100.

The circuit board 200 may include a driving circuit including thin film transistor (TFT) cells. In one or more embodiments, the circuit board 200 may further include other circuits than driving circuits for a display apparatus. In one or more embodiments, the circuit board 200 may include a flexible board, and the display apparatus 10 may be implemented as a display apparatus having a curved profile.

The pixel array 100 may have a display region DA and a peripheral region PA positioned on at least one side of the display region DA. The display region DA may include a light-emitting diode (LED) module for display. The pixel array 100 may have a display region DA in which the plurality of pixels PX are arranged. The peripheral region PA may include pad regions PAD, a connection region CR connecting the plurality of pixels PX and the pad regions PAD to each other, and an edge region ISO.

Each of the plurality of pixels PX may include first to third subpixels SP1, SP2, and SP3 configured to emit light having different colors so as to provide a color image. For example, the first to third subpixels SP1, SP2, and SP3 may be configured to emit red (R) light, green (G) light, and blue (B) light, respectively.

In one or more embodiments, in each pixel PX (also referred to as a "unit pixel"), the first to third subpixels SP1, SP2, and SP3 may be arranged in a Bayer pattern. As illustrated in FIG. 2, each pixel PX may include first and third subpixels SP1 and SP3 (for example, red (R) and blue (B)) arranged in a first diagonal direction, and two second subpixels SP2 (for example, green (G)) arranged in a second diagonal direction, intersecting the first diagonal direction. In one or more embodiments, each pixel PX is illustrated as including the first to third subpixels SP1, SP2, and SP3 arranged in a 2×2 Bayer pattern. However, embodiments are not limited thereto. In one or more embodiments, each pixel PX may be configured in another arrangement such as 3×3 or 4×4. In addition, in one or more embodiments, each pixel PX may include a subpixel configured to emit light, for example, yellow light, having a color different from the exemplified colors (R), (G), and (B). In the pixel array 100 in FIG. 1, it is illustrated that the plurality of pixels PX are arranged in a 15×15 grid. However, rows and columns may be implemented in any suitable number, for example, 1,024×768 or 1,800×1,350. For example, depending on a desired resolution, the plurality of pixels PX may have different arrangements.

The frame 11 may be a guide structure surrounding the pixel array 100. The frame 11 may include, for example, at least one of materials such as a polymer, ceramic, a semiconductor, or a metal. For example, the frame 11 may include a black matrix. However, the frame 11 is not limited to a black matrix, and may include a white matrix or a structure having another color depending on a purpose of the display apparatus 10. For example, the white matrix may include a reflective material or a scattering material. The display apparatus 10 in FIG. 1 is illustrated as having a rectangular planar structure, but may have a different shape depending on embodiments.

A plurality of LED cells LC1, LC2, and LC3 may respectively have a micro-LED structure, and may be formed to respectively correspond to the first to third subpixels SP1, SP2, and SP3. The LED cells LC1, LC2, and LC3 may be arranged in a plurality of rows and a plurality of columns, in a plan view (see FIG. 2). The plurality of LED cells LC1, LC2, and LC3 may be provided as light sources of the subpixels SP1, SP2, and SP3, and may include active layers 114R, 114G, and 114B emitting light having different wavelengths. Each of first LED cells LC1 may include a first active layer 114R configured to emit red light, for example, light having a wavelength of 620 nm to 660 nm, and may be provided as a red subpixel SP1. Each of second LED cells LC2 may include a second active layer 114G configured to emit green light, for example, light having a wavelength of 510 nm to 550 nm, and may be provided as a green subpixel SP2. Each of third LED cells LC3 may include a third active layer 114B configured to emit blue light, for example, light having a wavelength of 430 nm to 480 nm, and may be provided as a blue subpixel SP3.

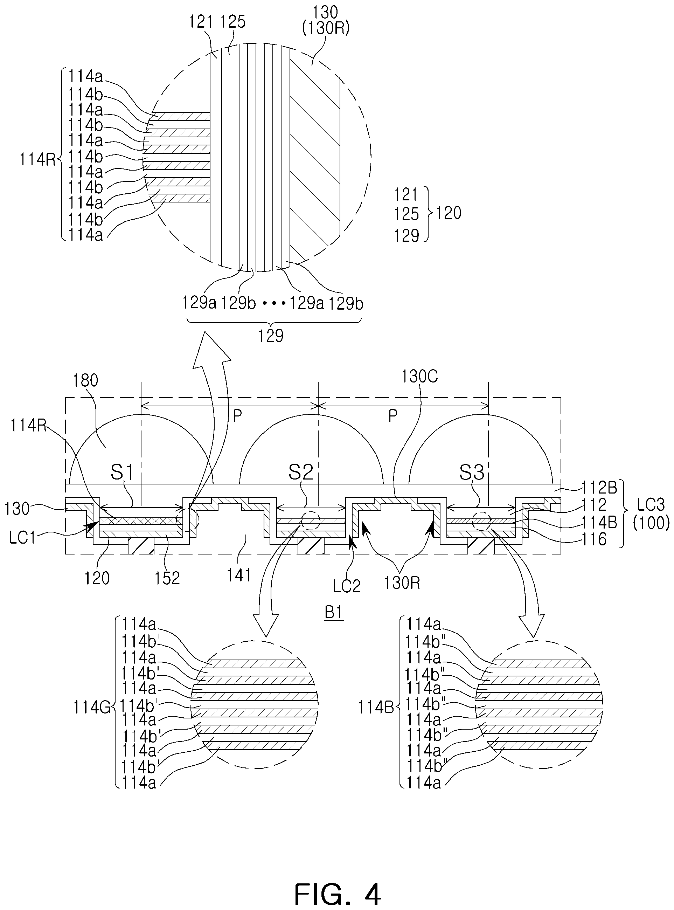

The first to third active layers 114R, 114G, and 114B may have different luminous efficiencies depending on an emission wavelength. For smooth color reproduction of the display apparatus 10, it may be necessary to reduce a variation between amounts of light emitted from different subpixels SP1, SP2, and SP3. In general, a higher emission wavelength may have lower luminous efficiency, and thus an LED cell (for example, LC1), emitting light having a relatively high wavelength, may be formed to have an area, larger than that of an LED cell (for example, LC2 or LC3), emitting light having a relatively low wavelength. In one or more embodiments, the area of the first LED cell LC1 may be formed to be larger than the area of each of the other second and third LED cells LC2 and LC3, such that the first active layer 114R may have a relatively larger area. Such a configuration will be described in more detail with reference to FIGS. 3 and 4.

FIG. 3 illustrates a partial cross-section of the peripheral region PA of the display apparatus in FIG. 1, taken along line I-I', and a partial cross-section of the display region DA of the display apparatus in FIG. 2, taken along line II-II'.

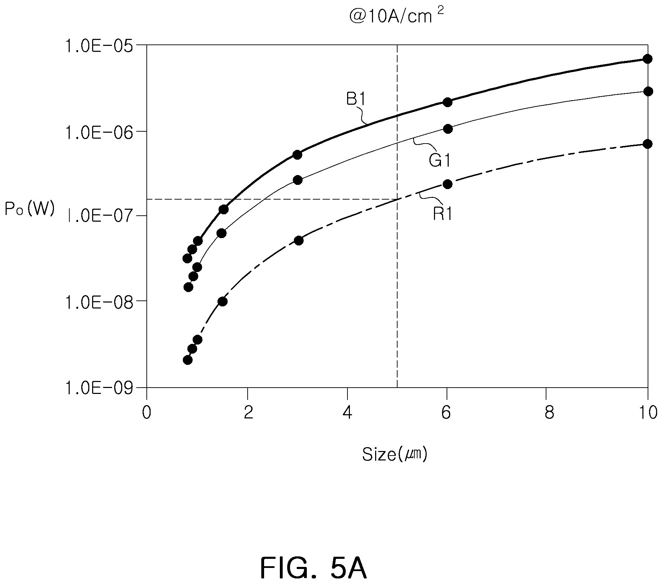

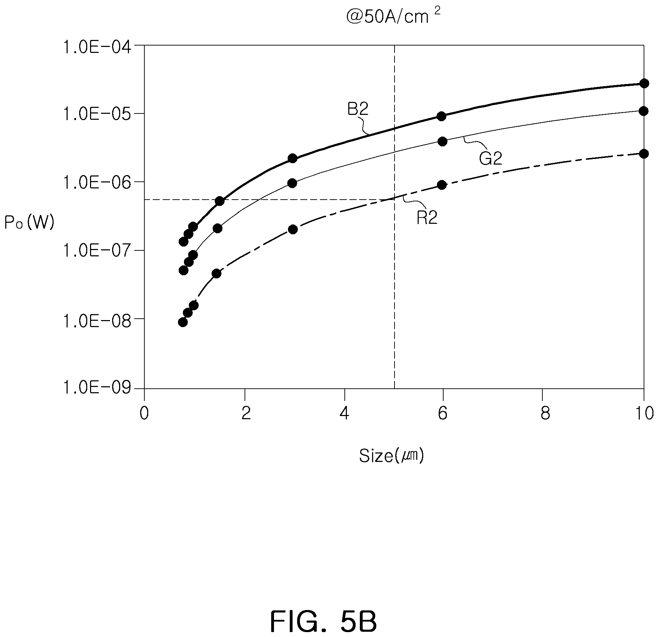

FIG. 4 is a partially enlarged cross-sectional view of portion "B1" of the display apparatus in FIG. 3 according to one or more embodiments. FIGS. 5A and 5B are graphs illustrating outputs of light-emitting diode (LED) cells according to an emission wavelength and a cell size, according to one or more embodiments.

As illustrated in FIG. 3, a semiconductor stack 110 may have a first surface facing the circuit board 200, and a second surface opposite to the first surface. In one or more embodiments, the first to third LED cells LC1, LC2, and LC3 may further include a first conductivity-type semiconductor base layer 112B disposed on the first conductivity-type semiconductor layer 112, the first conductivity-type semiconductor base layer 112B provided adjacent to the second surface of the semiconductor stack 110. The first conductivity-type semiconductor base layer 112B may have a single-layer structure shared by the first to third LED cells LC1, LC2, and LC3.

The first to third LED cells LC1, LC2, and LC3, provided as light sources of the subpixels SP1, SP2, and SP3, may include a semiconductor stack 110 configured to emit light having different wavelengths. Each semiconductor stack 110 may include a first conductivity-type semiconductor layer 112, active layers 114R, 114G, and 114B, and a second conductivity-type semiconductor layer 116. Here, at least the active layers 114R, 114G, and 114B may be configured to emit light having different wavelengths (for example, red, green, and blue), as described above.

FIGS. 5A and 5B illustrate changes in output depending on a size (or width) of each of LED cells at different applied current densities (10 A/cm² and 50 A/cm²), respectively.

Referring to FIGS. 5A and 5B, outputs Po of all LED cells R1, G1, B1, R2, G2, and B2 may increase as areas of the LED cells R1, G1, B1, R2, G2, and B2 increase. For the same area, outputs of red LED cells R1 and R2 may be lower than outputs of green LED cells G1 and G2 and blue LED cells B2 and B2. Similarly, for the same area, the outputs of the green LED cell G1 and G2 may be lower than those of the blue LED cells B1 and B2. As described, the red LED cells may tend to have lower efficiency in converting applied power into light, as compared to the green and blue LED cells.

In one or more embodiments, in order to reduce such a variation in light output, as described above, the first LED cell LC1 may have an area larger than those of the second and third LED cells LC2 and LC3.

Referring to FIG. 4, the first to third LED cells LC1, LC2, and LC3 may be arranged to have the same pitch P, and a width S1 of the first LED cell LC1 may be greater than widths S2 and S3 of the second and third LED cells LC2 and LC3. In one or more embodiments, the widths S2 and S3 of the second and third LED cells LC2 and LC3 may have relatively a small variation in luminous efficiency (see FIGS. 5A and 5B), and thus may have almost the same area (S2=S3). Here, the pitch P may be defined as a distance between central portions of adjacent LED cells, and respective cells LC1, LC2, and LC3 may have the same planar cross-sectional shape (for example, a circular shape, a hexagonal shape, or a rectangular shape), and may have widths respectively proportional to areas thereof.

For example, the width S1 of the first LED cell LC1 may be 5 µm or less. The widths S2 and S3 of the second and third LED cells LC2 and LC3 may be less than the width S1 of the first LED cell LC1. As described, an output variation may be sufficiently reduced by adjusting the widths of the first to third LED cells LC1, LC2, and LC3. It may not be necessary to adjust the widths of the first to third LED cells LC1, LC2, and LC3 such that the first to third LED cells LC1, LC2, and LC3 have the same output.

The semiconductor stack 110 of the first to third LED cells LC1, LC2, and LC3 according to one or more embodiments may include a nitride epitaxial layer grown on the same board. A growth substrate may include a board for nitride single crystal growth, for example, at least one of sapphire, Si, SiC, MgAl₂O₄, MgO, LiAlO₂, LiGaO₂, and GaN. In one or more embodiments, in order to improve crystallinity and light extraction efficiency of the nitride epitaxial layers, the growth substrate may have an uneven structure on at least a portion of an upper surface thereof.

The nitride epitaxial layers for the first to third LED cells LC1, LC2, and LC3 may be selectively grown in a desired region using different masks, respectively. The nitride epitaxial layer may be formed using, for example, a metal organic chemical vapor deposition (MOCVD) process, a hydride vapor phase epitaxy (HVPE) process, or a molecular beam epitaxy (MBE) process.

As described above, the nitride epitaxial layer may include a first conductivity-type semiconductor base layer 112B, a first conductivity-type semiconductor layer 112, active layers 114R, 114G, and 114B, and a second conductivity-type semiconductor layer 116.

In one or more embodiments, the first to third active layers 114R, 114G, and 114B of each of the first to third LED cells may include quantum well layers 114b, 114b', and 114b" having different indium contents. In one or more embodiments, the first to third active layers 114R, 114G, and 114B may respectively have a multiple quantum well MQW structure in which quantum barrier layers 114a and quantum well layers 114b, 114b', and 114b" are alternately arranged. For example, the quantum well layers 114b, 114b', and 114b" may be InₓGa₁₋ₓN (0<x≤1) layers, and the quantum barrier layer 114a may be GaN layers or AlGaN layers. For example, the quantum well layer 114b of the first active layer 114R may have an indium content of 25% to 35%, and the quantum well layers 114b' and 114b" of the second and third active layers 114G and 114B may respectively have an indium content of 15% to 20% and an indium content of 10% to 15%.

As an indium content increases, a growth temperature may be relatively lowered and a piezoelectric field may increase, such that luminous efficiency may be significantly low. As described with reference to FIGS. 5A and 5B, LED cells, emitting long-wavelength light, may have relatively low efficiency, and such a variation may be reduced by allowing the LED cells to have different areas.

In addition, the first to third active layers 114R, 114G, and 114B may be designed differently, thereby reducing a variation in light output depending on a wavelength (for example, color). Specifically, as illustrated in FIG. 4, the first to third active layers 114R, 114G, and 114B may include different numbers of pairs of quantum well layers 114b, 114b', and 114b" and quantum barrier layers 114a, or different numbers of quantum well layers 114b, 114b', and 114b", thereby alleviating such a variation in luminous efficiency. For example, the number (for example, five) of quantum well layers 114b of the first active layer 114R may be configured to be greater than the number (for example, three) of quantum well layers 114b" and 114b" of the second and third active layers 114G and 114B. In one or more embodiments, the number of quantum well layers 114b' of the second active layer 114G may be configured to be greater than the number of quantum well layers 114b" of the third active layers 114B.

The first conductivity-type semiconductor base layer 112B and the first conductivity-type semiconductor layer 112 may respectively be a nitride epitaxial layer having a composition of N-type InₓAl_{y}Ga_{1-x-y}N (0≤x<1, 0≤y<1, 0≤x+y<1). For example, the first conductivity-type semiconductor layer 112 may be an N-type gallium nitride (n-GaN) layer doped with silicon (Si), germanium (Ge), or carbon (C). The second conductivity-type semiconductor layer 116 may be a nitride semiconductor layer having a composition of P-type InₓAl_{y}Ga_{1-x-y}N(0≤x<1, 0≤y<1, 0≤x+y<1). For example, the second conductivity-type semiconductor layer 116 may be a P-type gallium nitride (p-GaN) layer doped with magnesium (Mg) or zinc (Zn). The first conductivity-type semiconductor layer 112 and the second conductivity-type semiconductor layer 116 may respectively include a single layer, but may also include a plurality of layers having different properties such as doping concentration, composition, and the like.

Referring to FIGS. 3 and 4, the plurality of LED cells LC1, LC2, and LC3 may include a contact electrode 152, positioned on the second conductivity-type semiconductor layers 116. The contact electrode 152 may include a highly reflective ohmic contact material or a transparent electrode material.

The first to third LED cells LC1, LC2, and LC3 according to one or more embodiments may include the semiconductor stack 110 (112, 114, and 116) having an upper surface, a (0001) plane, and a side surface, almost perpendicular to a first surface of the first conductivity-type semiconductor base layer 112B. For example, an upper surface of the second conductivity-type semiconductor layer 116 may be a (0001) plane. The side surfaces of the first to third LED cells LC1, LC2, and LC3 may be almost vertical side surfaces using an etching process. For example, the side surfaces of the first to third LED cells LC1, LC2, and LC3 may have an angle ranging from 85° to 95°. Defective regions of the side surfaces, causing leakage current, may be removed using the etching process.

Referring to FIGS. 3 and 4, a passivation layer 120 may be formed to cover side surfaces and upper surfaces of the first to third LED cells LC1, LC2, and LC3. In one or more embodiments, the passivation layer 120 may be formed up to a portion of the first conductivity-type semiconductor base layer 112B between the first to third LED cells LC1, LC2, and LC3. In addition, the passivation layer 120 may extend to a region of the first conductivity-type semiconductor base layer 112B, positioned in the peripheral region PA. Specifically, the passivation layer 120 may be disposed to cover a lower surface of the first conductivity-type semiconductor base layer 112B in the connection region CR and the pad regions PAD, that is, in the peripheral region PA.

The passivation layer 120 may include at least one of an insulating material, for example, SiO2, SiN, SiCN, SiOC, SiON, SiOCN, HfOₓ, AlOₓ, ZrOₓ, and AlN.

The passivation layer 120 according to one or more embodiments may include a first insulating layer 121 contacting surfaces of the plurality of LED cells LC1, LC2, and LC3, and a second insulating layer 125 on the first insulating layer 121. The first insulating layer 121 may be provided as a layer for curing defects on surfaces of the plurality of LED cells LC1, LC2, and LC3, in particular, defects on a side surface of the nitride epitaxial layer. The first insulating layer 121 may include at least one of ZrO₂, Al₂O₃, and HfO₂. The first insulating layer 121 may be conformally formed along the surfaces of the LED cells LC1, LC2, and LC3. For example, the first insulating layer 121 may be formed using an atomic layer deposition (ALD) process. In one or more embodiments, the first insulating layer 121 may have a multilayer structure. For example, the first insulating layer 121 may include a multilayer structure of ZrO₂/Al₂O₃/ZrO₂. Each layer of the multilayer structure may have a thickness of about 1 nm to about 10 nm. For example, the second insulating layer 125 may include at least one of SiO₂, SiN, SiCN, SiOC, SiON, and SiOCN.

In one or more embodiments, the passivation layer 120 may further include a distributed Bragg reflector (DBR) layer 129 on the second insulating layer 125. The DBR layer 129 may be formed by alternately stacking first and second dielectric layers 129a and 129b having different refractive indices.

In one or more embodiments, the first connection electrode 130 may have a contact region 130C connected to the first conductivity-type semiconductor base layer 112B. Specifically, the first connection electrode 130 may directly contact the first conductivity-type semiconductor base layer 112B in a region between adjacent LED cells LC1, LC2, and LC3. In addition, the first connection electrode 130 may be disposed to be electrically insulated from the first to third LED cells LC1, LC2, and LC3 by the passivation layer 120.

The first connection electrode 130 may be provided as a reflective electrode configured to reflect light emitted from the upper surfaces of the first to third LED cells LC1, LC2, and LC3. The first connection electrode 130 may have a reflective region 130R extending to the side surfaces of the LED cells. In a plan view, the first connection electrode 130 may have an integrated structure in which regions between adjacent first to third LED cells LC1, LC2, and LC3 are connected to each other. For example, the first connection electrode 130 may have a side cross-section having an inverted U shape between adjacent LED cells LC1, LC2, and LC3, and may have a grid or mesh shape extending in a X-direction and a Y-direction.

The first connection electrode 130 may include a reflective material, for example, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), copper (Cu), titanium (Ti), tantalum (Ta), and tungsten (W). In one or more embodiments, the first connection electrode 130 may include a compound such as TaN or TiN, or a transparent electrode material such as ITO, IZO, or GAZO. In one or more embodiments, the first connection electrode 130 may have a single-layer or multilayer structure of a conductive material.

As illustrated in FIG. 3, the first connection electrode 130 may have an extension portion 130E extending from the display region DA to the peripheral region PA. In the connection region CR, a common electrode 145 may be disposed on the extension portion 130E of the first connection electrode 130. The pad electrode 147 may be positioned in the pad region PAD, may be positioned on a gap-fill insulating layer 141 in a similar manner to the common electrode 145, and may be connected to a bonding pad 199.

The pixel array 100 may further include a gap-fill insulating layer 141 covering side surfaces and lower surfaces of the plurality of LED cells LC1, LC2, and LC3, and second connection electrodes 155 passing through the gap-fill insulating layer 141, the second connection electrodes 155 being connected to the contact electrode 152 of the plurality of LED cells LC1, LC2, and LC3.

An upper bonding structure 190 may include an upper bonding insulating layer 191 disposed on a lower surface of the gap-fill insulating layer 141, and upper bonding electrodes 195 divided into a first to third upper bonding electrodes 195A to 195C. The first and second upper bonding electrodes 195A and 195B may be respectively electrically connected to the first and second connection electrodes 130 and 155 in the upper bonding insulating layer 191. The upper bonding electrodes 195 may have a post-like shape. Lower surfaces of the upper bonding electrodes 195 may be flat surfaces, substantially coplanar with a lower surface of the upper bonding insulating layer 191. The coplanar surface may be a lower surface of the pixel array 100, and may be provided as a bonding surface for bonding to the circuit board 200. The upper bonding electrodes 195 may include a conductive material, for example, copper (Cu). For example, the upper bonding insulating layer 191 may include at least one of SiO, SiN, SiCN, SiOC, SiON, and SiOCN.

As described above, the common electrode 145 and the pad electrode 147 may be disposed in the connection region CR and the pad regions PAD, respectively. The common electrode 145, together with the first connection electrode 130, may be provided as a common electrode structure for driving the LED cells LC1, LC2, and LC3. The pad electrode 147 may be disposed to contact the bonding pad 199 in the pad regions PAD. The common electrode 145 and the pad electrode 147 may include a conductive material, for example, at least one of silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), and gold (Au). For example, the bonding pad 199 may include at least one of gold (Au), silver (Ag), and nickel (Ni).

In one or more embodiments, depending on a connection target, a first upper bonding electrode 195A may be electrically connected to the first connection electrode 130, second upper bonding electrodes 195B may be respectively electrically connected to the second connection electrodes 155, and a third upper bonding electrode 195C may be connected to the pad electrode 147.

As illustrated in FIG. 3, the first upper bonding electrode 195A may pass through the upper bonding insulating layer 191 and the gap-fill insulating layer 141 and land on the common electrode 145, and may be, in common, connected to one side (in particular, the first conductivity-type semiconductor base layer 112B) of each of the LED cells LC1, LC2, and LC3 through the common electrode 145 and the first connection electrode 130. The second upper bonding electrodes 195B may pass through the upper bonding insulating layer 191 and respectively land on the second connection electrodes 155, and may be individually connected to the other side (in particular, the second conductivity-type semiconductor layer 116) of each of the LED cells LC1, LC2, and LC3 through the second connection electrode 155 and the contact electrode 152. In addition, the third upper bonding electrode 195C may pass through the upper bonding insulating layer 191 and the gap-fill insulating layer 141 and land on the pad electrode 147, and may be connected to the bonding pad 199 for connection to an external circuit through the pad electrode 147.

Referring to FIG. 3, the circuit board 200 according to one or more embodiments may include a device board 201 on which elements 220 for a driving circuit are disposed, and a lower bonding structure 290 disposed on the device board 201. The circuit board 200 may include an interlayer connection structure 230 between the device board 201 and the lower bonding structure 290. The interlayer connection structure 230 may include an interconnection line insulating layer 231 on the device board 201, and an interconnection line circuit 235 electrically connected to the driving elements 220 in the interconnection line insulating layer 231. The elements 220 for the driving circuit may include TFT cells.

The device board 201 may be a semiconductor board having impurity regions having source/drain regions 205. The device board 201 may include, for example, a semiconductor such as silicon (Si) or germanium (Ge), or a compound semiconductor such as SiGe, SiC, GaAs, InAs, or InP. The device board 201 may further include through-electrodes 250 such as a through-silicon via (TSV), connected to the driving circuit, and first and second substrate wiring lines 261 and 262 connected to the through-electrodes 250.

The driving circuit may include a circuit for controlling driving of a pixel, in particular, a sub-pixel. The source/drain region 205 of the TFT cells may be electrically connected to one side of each of the LED cells LC1, LC2, and LC3 through the interlayer connection structure 230 and the lower bonding structure 290. For example, a source/drain region 205 of the TFT cells may be connected to a data line through the interconnection line circuit 235. Gate electrodes of the TFT cells may be connected to a gate line through the interconnection line circuit 235. A configuration and an operation of the circuit will be described in more detail with reference to FIG. 5 below.

The lower bonding structure 290 may include a lower bonding insulating layer 291 and lower bonding electrodes 295 embedded in the lower bonding insulating layer 291, the lower bonding electrodes 295 electrically connected to the driving circuit. The lower bonding electrodes 295 may be electrically connected to the driving circuit through the interconnection line circuit 235. For example, the lower bonding electrodes 295 may have a pillar structure. Upper surfaces of the lower bonding electrodes 295 may be flat surfaces, substantially coplanar with an upper surface of the lower bonding insulating layer 291. The coplanar surface may be an upper surface of the circuit board 200, and may be provided as a bonding surface for bonding to the pixel array 100. The lower bonding electrodes 295 may include a conductive material, for example, copper (Cu). For example, the lower bonding insulating layer 291 may include at least one of SiO, SiN, SiCN, SiOC, SiON, and SiOCN.

The lower bonding electrodes 295 of the circuit board 200 and the upper bonding electrodes 195 of the pixel array 100 may be bonded to each other to provide an electrical connection path between the circuit board 200 and the pixel array 100. In addition, the upper bonding insulating layer 191 of the pixel array 100 may be bonded to the lower bonding insulating layer 291 of the circuit board 200.

As described, the circuit board 200 and the pixel array 100 may be coupled to each other by bonding between the lower bonding electrodes 295 and the upper bonding electrodes 195 and bonding between the lower bonding insulating layer 291 and the upper bonding insulating layer 191. Bonding between the lower bonding electrodes 295 and the upper bonding electrodes 195 may be, for example, copper (Cu)-copper (Cu) bonding, and bonding between the lower bonding insulating layer 291 and the upper bonding insulating layer 191 may be dielectric-dielectric bonding, for example, dielectric-dielectric bonding such as SiCN-SiCN bonding. The circuit board 200 and the pixel array 100 may be bonded to each other by hybrid bonding including copper (Cu)-copper (Cu) bonding and dielectric-dielectric bonding, and may be bonded to each other without an adhesive layer.

Depending on a connection target, the lower bonding electrodes 295 may be divided into first to third lower bonding electrodes 295A, 295B, and 295C, respectively, in a similar manner to the upper bonding electrodes 195.

Specifically, the first lower bonding electrode 295A may be bonded to the first upper bonding electrode 195A, and each of the first connection electrodes 130 may be electrically connected to the driving circuit through the common electrode 145. The second lower bonding electrodes 295B may be respectively bonded to the second upper bonding electrodes 195B to electrically connect the second connection electrode 155, an individual electrode, to the driving circuit.

As described, the plurality of LED cells LC1, LC2, and LC3 may be connected to the driving circuit by bonding between the first upper and lower bonding electrodes 195A and 295A and bonding between the second upper and lower bonding electrodes 195B and 295B, such that the plurality of LED cells LC1, LC2, and LC3 may be individually driven.

Additionally, the third lower bonding electrodes 295C are bonded to the third upper bonding electrodes 195C, respectively, so that the bonding pad 199 may be electrically connected to the driving circuit through the pad electrode 147.

In one or more embodiments, the lower bonding electrodes 295 may further include a lower dummy bonding electrode 295D, not connected to the driving circuit. Similarly, the upper bonding electrodes 195 may further include an upper dummy bonding electrode 195D connected to the lower dummy bonding electrode 295D, the upper dummy bonding electrode 195D not connected to the plurality of LED cells LC1, LC2, and LC3. The upper and lower dummy bonding electrodes 195D and 295D may be arranged at regular intervals from the other upper and lower bonding electrodes 195 and 295 over the entire area. In one or more embodiments, the upper dummy bonding electrode 195D may be formed on a dummy pad 155D not connected to the plurality of LED cells LC1, LC2, and LC3, and the dummy pad 155D may be formed together with the second connection electrodes 155.

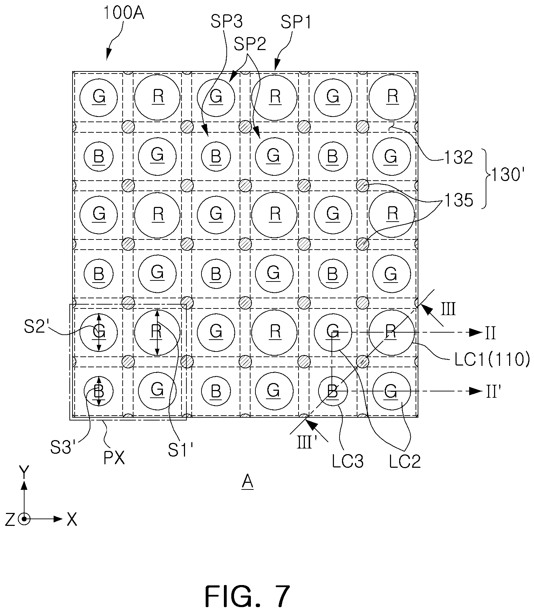

Microlenses 180 may be disposed on each of the LED cells LC1, LC2, and LC3 to converge light emitted from the LED cells LC1, LC2, and LC3. In one or more embodiments, the microlenses 180 may be disposed on the first conductivity-type semiconductor base layer 112B. For example, the microlenses 180 may have a diameter greater than the widths of the LED cells LC1, LC2, and LC3 in the X-direction and the Y-direction. The microlenses 180 may be configured to adjust an orientation angle of light emitted from the LED cells LC1, LC2, and LC3. The microlenses 180 may be formed of, for example, a transparent photoresist material or a transparent thermosetting resin film. The microlenses 180 according to one or more embodiments may have the same shape and size. However, in one or more embodiments, the microlenses 180 may have different shapes and/or sizes depending on the areas of the first to third LED cells LC1, LC2, and LC3. Or it may have a different size (see FIG. 7).

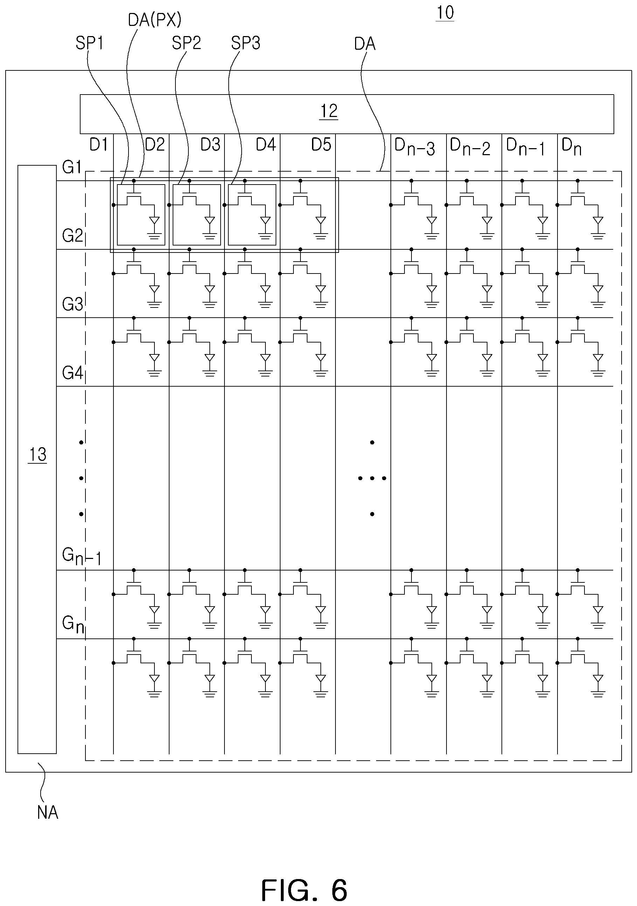

FIG. 6 is a diagram of a driving circuit implemented in a display apparatus according to one or more embodiments.

Referring to FIG. 6, a circuit diagram of a display apparatus 10 in which n×n subpixels are arranged is illustrated. The first to third subpixels SP1, SP2, and SP3 may respectively receive a data signal through data lines D1 to Dn, paths in a vertical direction, for example, a column direction. The first to third subpixels SP1, SP2, and SP3 may receive a control signal, that is, a gate signal, through gate lines G1 to Gn, paths in a horizontal direction, for example, a row direction.

A plurality of pixels PX including the first to third sub-pixels SP1, SP2, and SP3 may provide a display region DA, and the display region DA, an active region, may be provided as a display region for a user. An inactive region NA (or a peripheral region PA) may be formed along one or more edges of the display region DA. The inactive region NA may extend along an outer periphery of a panel of the display apparatus 10.

First and second driver circuits 12 and 13 may be used to control operation of the pixels PX, that is, the first to third subpixels SP1, SP2, and SP3. A portion or all of the first and second driver circuits 12 and 13 may be implemented in the circuit board 200. The first and second driver circuits 12 and 13 may be configured as integrated circuits, thin film transistor panel circuits, or other suitable circuits, and may be disposed in the inactive region NA of the display apparatus 10. The first and second driver circuits 12 and 13 may include a microprocessor, a memory such as storage, a processing circuit, and a communication circuit.

In order to display an image by the pixels PX, the first driver circuit 12 may supply image data to the data lines D1 to Dn, and may transmit a clock signal and other control signals to the second driver circuit 13, a gate driver circuit. The second driver circuit 13 may be implemented using an integrated circuit and/or a thin film transistor circuit. A gate signal for controlling the first to third subpixels SP1, SP2, and SP3 arranged in the row direction may be transmitted through the gate lines G1 to Gn of the display apparatus 10.

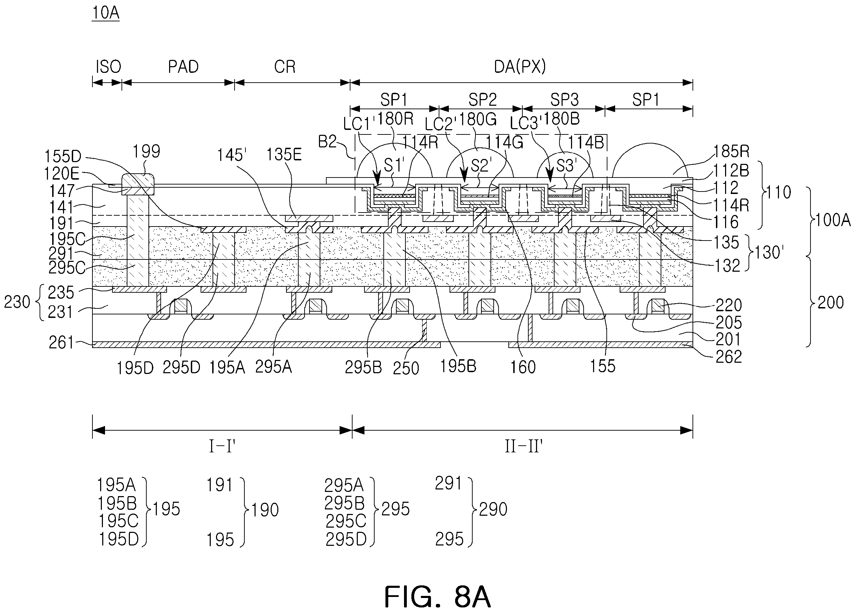

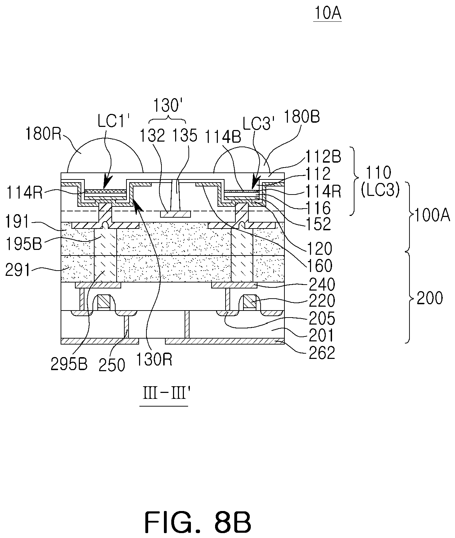

FIG. 7 is a plan view of a display apparatus according to one or more embodiments. FIGS. 8A and 8B are cross-sectional views of a display apparatus according to one or more embodiments.

Here, FIG. 7 may be understood as a cross-section corresponding to portion "A" in FIG. 1, in a similar manner to FIG. 2, and FIG. 8A illustrates a partial cross-section of the peripheral region PA of the display apparatus in FIG. 1, taken along line I-I', and a partial cross-section of the display region DA of the display apparatus in FIG. 7, taken along line II-II', in a similar manner to FIG. 3, and FIG. 8B illustrates another partial cross-section of the display region DA of the display apparatus in FIG. 7, taken along line III-III'.

Referring to FIGS. 7, 8A, and 8B, a display apparatus 10A (comprising a pixel array 100A and circuit board 200) according to one or more embodiments may be understood as being similar to the display apparatus 10 illustrated in FIGS. 1 to 6, except that first to third LED cells LC1, LC2, and LC3 all have different sizes, microlenses 180R, 180G, and 180B are configured to have different sizes depending on the sizes of the LED cells LC1, LC2, and LC3, and a first connection electrode 130' and a reflective layer 160 are provided as separate structures. In addition, unless otherwise described, components of one or more embodiments may be understood with reference to descriptions of the same or similar components of the display apparatus 10 illustrated in FIGS. 1 to 6.

In one or more embodiments, the first to third LED cells LC1, LC2, and LC3 may be configured to have different sizes (S1'>S2'>S3') to reduce a variation in light output depending on an emission wavelength (for example, color). The first LED cell LC1, emitting red light, may have a width S1' greater than widths S2' and S3' of the second and third LED cells LC2 and LC3. In one or more embodiments, the second LED cell LC2, emitting green light, may have a width S2' greater than a width S3' of the third LED cell LC3, emitting blue light. In addition, as described with reference to FIG. 4, first to third active layers 114R, 114G, and 114B may be designed differently, thereby further reducing a variation in light output depending on an emission wavelength.

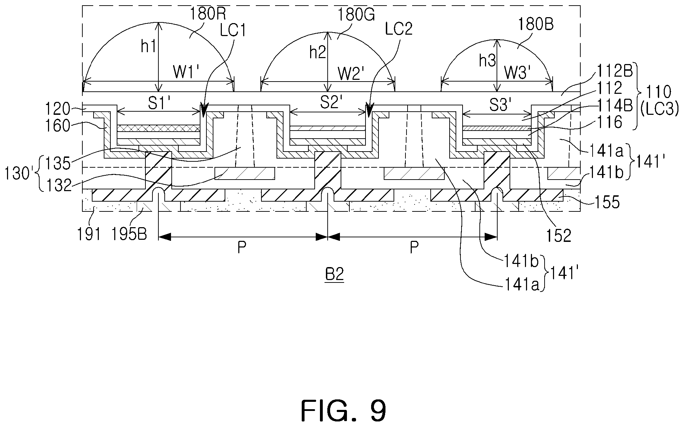

FIG. 9 is a partially enlarged cross-sectional view of portion "B2" of the display apparatus in FIG. 8A according to one or more embodiments.

Referring to FIG. 9, a plurality of microlenses may include a first microlens 180R on the first LED cell LC1, a second microlens 180G on the second LED cell LC2, and a third microlens 180B on the third LED cell LC3, and the first to third microlenses 180R, 180G, and 180B may have different sizes. A lens size may be defined by widths W1', W2', and W3' and heights h1, h2, and h3 of a lens. A width W1' of the first microlens 180R may be greater than widths W2' and W3' of the second and third microlenses 180G and 180B, and the width W2' of the second microlens 180G may be greater than the width W3' of the third microlens 180B. Similarly, the first to third microlenses 180R, 180G, and 180B may have different heights (h1>h2>h3).

As described, the first to third microlenses 180R, 180G, and 180B may be formed to have different sizes, thereby adjusting an orientation angle of light emitted from the first to third LED cells LC1, LC2, and LC3 in a desired range, regardless of a cell area.

In one or more embodiments, the first connection electrode 130' and the reflective layer 160 may be configured separately. Referring to FIGS. 7 to 9, the first connection electrode 130' according to one or more embodiments may include contact vias 135 connected to a first conductivity-type semiconductor base layer 112B, and an electrode pattern 132 connected to the contact vias 135. In a plan view (see FIG. 7), the contact vias 135 may be aligned between LED cells LC1, LC2, and LC3 adjacent to each other in a diagonal direction, and the electrode pattern 132 may be connected to the contact vias 135 to have a grid or mesh shape. In one or more embodiments, a gap-fill insulating layer 141' may include a first gap-fill insulating layer 141a and a second gap-fill insulating layer 141b, sequentially stacked. The contact vias 135 may pass through the first gap-fill insulating layer 141a, and may be connected to the first conductivity-type semiconductor base layer 112B. In addition, the electrode pattern 132 may be provided as a common electrode structure connected to each of the contact vias 135, on the first gap-fill insulating layer 141a, and the second gap-fill insulating layer 141b may be formed on the first gap-fill insulating layer 141a to cover the electrode pattern 132.

In one or more embodiments, the first connection electrode 130' may have an extension portion 135E extending from the first gap-fill insulating layer 141a to a connection region CR. The common electrode 145' may be disposed on the second gap-fill insulating layer 141b, and may be connected to the extension portion 135E of the first connection electrode 130' through the second gap-fill insulating layer 141b. In one or more embodiments, the common electrode 145' may be formed together with a second connection electrode 155.

The reflective layer 160 according to one or more embodiments may be disposed on the contact electrode 152, and may include a reflective electrode extending to side surfaces of a plurality of LED cells LC1, LC2, and LC3. The reflective layer 160 may also be used as a portion of a contact structure, and may be provided as a reflective structure, effectively covering a lower surface of each of the LED cells LC1, LC2, and LC3. The passivation layer 120 according to one or more embodiments may be provided without a DBR layer.

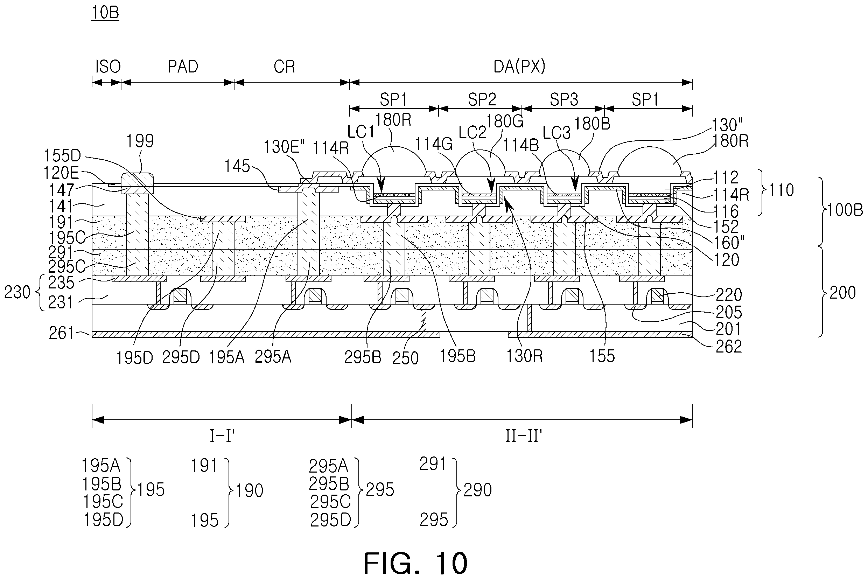

FIG. 10 is a cross-sectional view of a display apparatus according to an example embodiment of the present inventive concept.

Referring to FIG. 10, a display apparatus 10B (comprising a pixel array 100B and a circuit board 200) according to one or more embodiments may be understood as being similar to the display apparatus 10 illustrated in FIGS. 1 to 6, except that a plurality of LED cells LC1, LC2, and LC3 are physically separated from each other, a first connection electrode 130" is disposed on a gap-fill insulating layer 141, and a first microlens 180R has a size larger than those of second and third microlenses 180G and 180B. In addition, unless otherwise described, components of one or more embodiments may be understood with reference to descriptions of the same or similar components of the display apparatus 10 illustrated in FIGS. 1 to 6.

Each of the first to third LED cells LC1, LC2, and LC3 may include a semiconductor stack including a first conductivity-type semiconductor layer 112, a second conductivity-type semiconductor layer 116, and active layers 114B, 114G, and 114R between the first and second conductivity-type semiconductor layers 112 and 116. In one or more embodiments, the semiconductor stacks may be separated into LED cells.

A passivation layer 120 may be disposed on lower surfaces and side surfaces of the first to third LED cells LC1, LC2, and LC3. A reflective metal layer 160" may be disposed on the passivation layer 120. For example, the reflective metal layer 160" may include at least one selected from the group consisting of Ag, Ni, Al, Rh, Ru, and combinations thereof.

The first conductivity-type semiconductor layer 112 of each of the LED cells may have a protruding portion, provided as a light emission surface, on an upper surface of a gap-fill insulating layer 141. The semiconductor stack 110 may be understood as epitaxial layers grown on a single growth substrate. The first connection electrode 130" may be disposed on the gap-fill insulating layer 141, and may be, in common, connected to each of the first conductivity-type semiconductor layers 112 of the plurality of LED cells LC1, LC2, and LC3. The first connection electrode 130" may be connected to the protruding portions of the first conductivity-type semiconductor layers 112. The common electrode 145 may be disposed in a connection region CR of the gap-fill insulating layer 141, and the first connection electrode 130" may have an extension portion 130E" connected to the common electrode 145.

In one or more embodiments, the first to third microlenses 180R, 180G, and 180B may be disposed on the protruding portions of the first conductivity-type semiconductor layer 112. Lens formation regions of the protruding portions may be defined by the first connection electrodes 130".

As illustrated in FIG. 10, the first to third microlenses 180R, 180G, and 180B may have different sizes depending on areas of the LED cells LC1, LC2, and LC3. A width W1' of the first microlens 180R may be greater than widths W2' and W3' of the second and third microlenses 180G and 180B, and the second and third microlenses 180G and 180B may have almost the same width (W2'=W3'). As described, the first to third microlenses 180R, 180G, and 180B may be formed to have different sizes, thereby adjusting an orientation angle of light emitted from the first to third LED cells LC1, LC2, and LC3 in a desired range, regardless of a cell area.

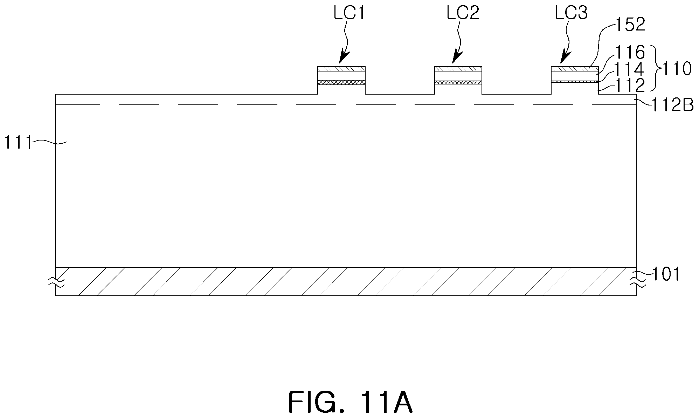

FIGS. 11A to 11E are cross-sectional views of a method of manufacturing of a display apparatus according to one or more embodiments. A method of manufacturing a display apparatus according to one or more embodiments may be understood as a process of manufacturing the display apparatus described with reference to FIGS. 1 to 6.

Referring to FIG. 11A, a semiconductor under layer 111 and a first conductivity-type semiconductor base layer 112B may be sequentially formed on a growth substrate 101, and a plurality of LED cells LC1, LC2, and LC3 may be formed. The plurality of LED cells LC1, LC2, and LC3 may respectively include a semiconductor stack 110 configured to emit light having different wavelengths (for example, colors). The semiconductor stack 110 of each LED cell may include a first conductivity-type semiconductor layer 112, first to third active layers 114R, 114G, and 114B, and a second conductivity-type semiconductor layer 116, sequentially stacked on the first conductivity-type semiconductor base layer 112B, and a contact electrode 152 may be formed on the second conductivity-type semiconductor layer 116.

The growth substrate 101 may be a board for growing a nitride single crystal, and may include, for example, at least one of sapphire, Si, SiC, MgAl₂O₄, MgO, LiAlO₂, LiGaO₂, and GaN. In one or more embodiments, in order to improve crystallinity and light extraction efficiency of semiconductor layers, the growth substrate 101 may have an uneven structure on at least a portion of an upper surface thereof.

The semiconductor under layer 111, the first conductivity-type semiconductor base layer 112B, the first conductivity-type semiconductor layer 112, the first to third active layers 114R, 114G, and 114B, and the second conductivity-type semiconductor layer 116 may be formed using, for example, an MOCVD process, an HVPE process, or an MBE process. In one or more embodiments, the semiconductor under layer 111 may include a buffer layer and an undoped nitride layer (for example, GaN). In this case, the buffer layer may be a layer for alleviating lattice defects of a first conductivity-type semiconductor layer 112, and may include an undoped nitride semiconductor such as undoped GaN, undoped AlN, and undoped InGaN. The first conductivity-type semiconductor base layer 112B and the first conductivity-type semiconductor layer 112 may be N-type nitride semiconductor layers such as N-type GaN, and the second conductivity-type semiconductor layer 116 may be a P-type nitride semiconductor layer such as P-type GaN/p-type AlGaN. The first to third active layers 114R, 114G, and 114B may have a single quantum well structure such as InGaN/GaN or a multiple quantum well structure. The contact electrode 152 may include a transparent electrode or a highly reflective ohmic contact layer.

The first to third LED cells LC1, LC2, and LC3 may be arranged to have the same pitch P, and a width S1 of the first LED cell LC1, having a high indium content and low luminous efficiency, may be greater than widths S2 and S3 of the second and third LED cells LC2 and LC3. As described, the widths of the first to third LED cells LC1, LC2, and LC3 may be adjusted, thereby reducing a variation in light output.

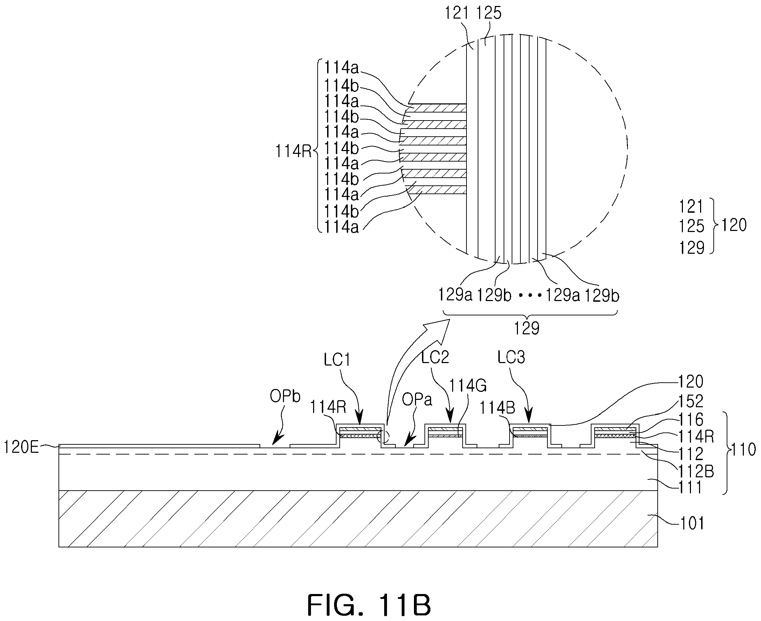

Subsequently, referring to FIG. 11B, a passivation layer 120 may be formed on the first to third LED cells LC1, LC2, and LC3, and first openings OPa may be formed to open a contact region of the first conductivity-type semiconductor base layer 112B, and a second opening OPb for a common electrode may be formed in a connection region.

The passivation layer 120 may be conformally formed on an upper surface of an epitaxial layer including the first to third LED cells LC1, LC2, and LC3. The passivation layer 120 may be formed using an ALD process. For example, the passivation layer 120 may include at least one of SiO₂, SiN, SiCN, SiOC, SiON, SiOCN, HfOₓ, AlOₓ, ZrOₓ, and AlN. The passivation layer 120 may include a first insulating layer 121 contacting surfaces of the plurality of LED cells LC1, LC2, and LC3, and a second insulating layer 125 on the first insulating layer 121. The first insulating layer 121 may be provided as a layer for curing surface defects of the plurality of LED cells LC1, LC2, and LC3. For example, the first insulating layer 121 may include at least one of ZrO₂, Al₂O₃, and HfO₂. In one or more embodiments, the first insulating layer 121 may include a multilayer structure of ZrO₂/Al₂O₃/ZrO₂. For example, the second insulating layer 125 may include at least one of SiO₂, SiN, SiCN, SiOC, SiON, and SiOCN. In one or more embodiments, the passivation layer 120 may further include a DBR layer 129 on the second insulating layer 125. The DBR layer 129 may be formed by alternately stacking first and second dielectric layers 129a and 129b having different refractive indices. The passivation layer 120 may be formed on a display region DA, and may have a passivation layer region 120E extending to a peripheral region PA.

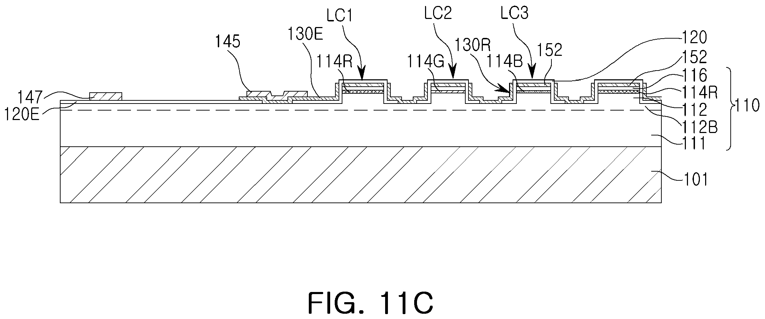

Subsequently, referring to FIG. 11C, a first connection electrode 130, a common electrode 145, and a pad electrode 147 may be formed.

First, the first connection electrode 130 may be formed on a region of the passivation layer 120 between the plurality of LED cells LC1, LC2, and LC3 to be connected to the first conductivity-type semiconductor base layer 112B through the first openings OPa. The first connection electrode 130 may extend onto side surfaces of the LED cells LC1, LC2, and LC3, and may be provided as a reflective layer.

Subsequently, the common electrode 145 and the pad electrode 147 may be formed on the passivation layer region 120E (see FIG. 3) extending onto the connection region CR and the pad regions PAD, respectively. The common electrode 145 may be connected to the first conductivity-type semiconductor base layer 112B through the second opening OPb. The common electrode 145 may be formed on the extension portion 130E of the first connection electrode 130, and the pad electrode 147 may be formed on the passivation layer 120. The common electrode 145 and the pad electrode 147 may be formed together through the same process.

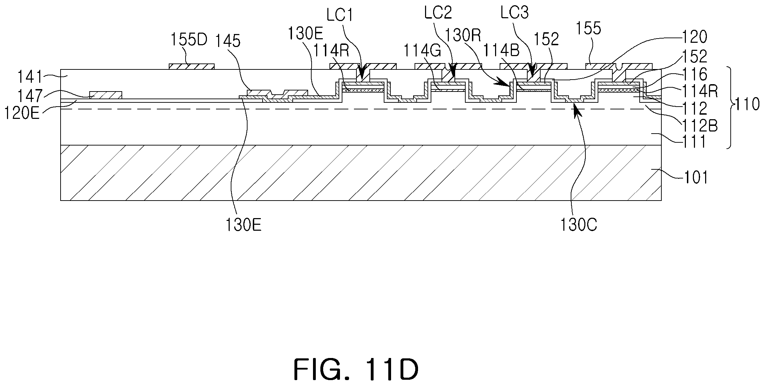

Subsequently, referring to FIG. 11D, a gap-fill insulating layer 141 may be formed, and second connection electrodes 155 connected to the contact electrodes 152 may be formed.

The gap-fill insulating layer 141 may be formed to cover all of the structures formed in the above-described operations, including the first connection electrode 130, and then a process of planarizing the gap-fill insulating layer 141 may be performed using a planarization process such as a chemical mechanical polishing (CMP) process or an etch-back process. For example, the gap-fill insulating layer 141 may be a low-κ material such as silicon oxide.

Contact holes may be formed to pass through the gap-fill insulating layer 141 and the passivation layer 120 and to respectively open contact electrodes 152, and the contact holes may be filled with a conductive material to form the second connection electrodes 155. A portion of the second connection electrodes 155 may extend onto the gap-fill insulating layer 141.

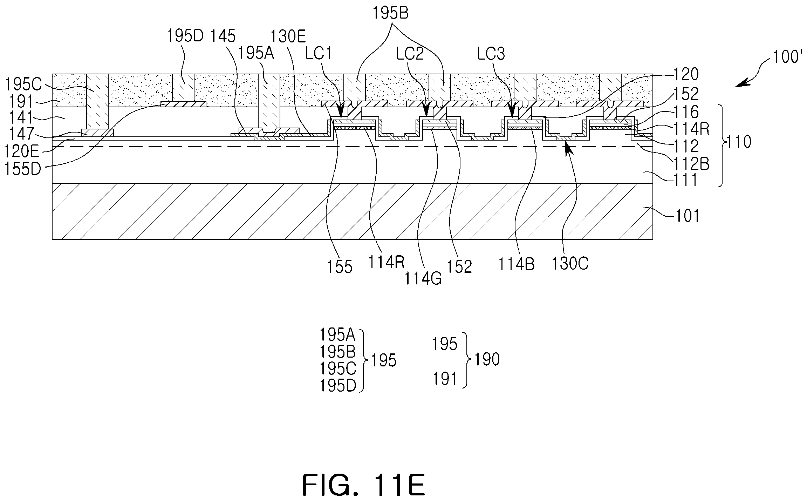

Subsequently, referring to FIG. 11E, an upper bonding insulating layer 191 may be formed on gap-fill insulating layer 141, and upper bonding electrodes 195 may be formed.

The upper bonding insulating layer 191 may include a material the same as or different from that of the gap-fill insulating layer 141. The upper bonding electrodes 195 may be formed by forming via holes through the upper bonding insulating layer 191 and the gap-fill insulating layer 141, filling the via holes with a conductive material, and planarizing the upper bonding insulating layer and the upper bonding electrode using a planarization process such as a CMP process. As a result, the upper bonding electrodes may have a flat upper surface, substantially coplanar with an upper surface of the upper bonding insulating layer.

Depending on a connection target, the upper bonding electrodes 195 may include a first upper bonding electrode 195A electrically connected to the first connection electrode 130, a second upper bonding electrodes 195B electrically connected to the second connection electrodes 155, and a third upper bonding electrode 195C connected to the pad electrode 147. In addition, the upper bonding electrodes 195 may further include an upper dummy bonding electrode 195D. The upper dummy bonding electrodes 195D may be arranged at regular intervals from the other upper bonding electrodes 195 over the entire area, such that a uniform planarization process may be performed over the entire area.

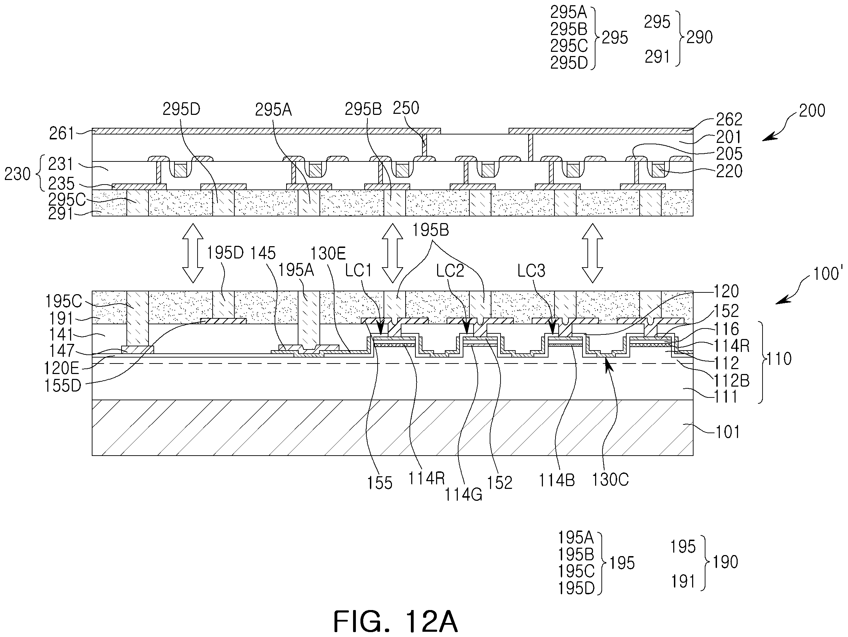

FIGS. 12A to 12C are cross-sectional views of a method of manufacturing a display apparatus according to one or more embodiments. FIGS. 12A to 12C may depict a bonding process.

First, referring to FIG. 12A, a pixel array structure including first to third LED cells LC1, LC2, and LC3 may be bonded to a circuit board 200.

The circuit board 200 may be prepared using a separated process. A pixel array 100' and the circuit board 200 may be bonded to each other at a wafer level using a wafer bonding method, for example, hybrid bonding described above. As described above, the circuit board 200 may include a lower bonding structure 290 having a lower bonding insulating layer 291 and lower bonding electrodes 295. The lower bonding electrodes 295 may be bonded to the upper bonding electrodes 195, respectively, and the lower bonding insulating layer 291 may be bonded to the upper bonding insulating layer 191. As described, the pixel array 100', including the LED cells LC1, LC2, and LC3, and the circuit board 200 may be bonded to each other without an adhesive layer.

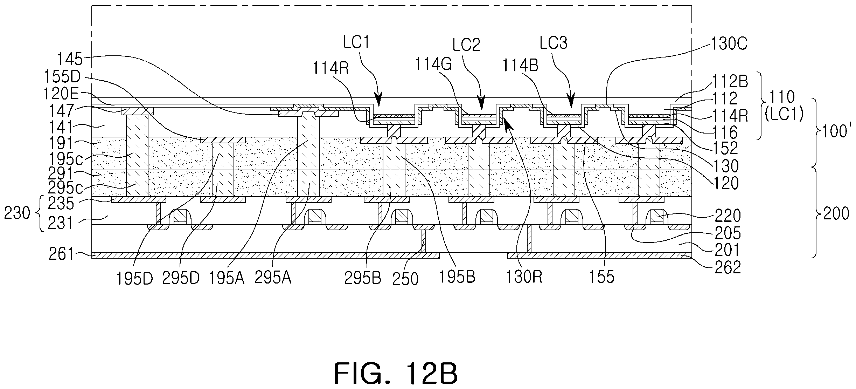

Subsequently, referring to FIG. 12B, the growth substrate 101 may be removed, and a portion of the semiconductor stack 110, that is, the semiconductor under layer 111, may be removed.

The growth substrate 101 may be removed using various processes such as a laser lift-off process, a mechanical polishing process or a mechanical chemical polishing process, or an etching process. The semiconductor under layer 111 may be partially removed, such that a thickness of the semiconductor under layer 111 may be reduced to a predetermined thickness using, for example, a polishing process such as a CMP process. After the semiconductor under layer 111 is removed, the first conductivity-type semiconductor base layer 112B may be exposed.

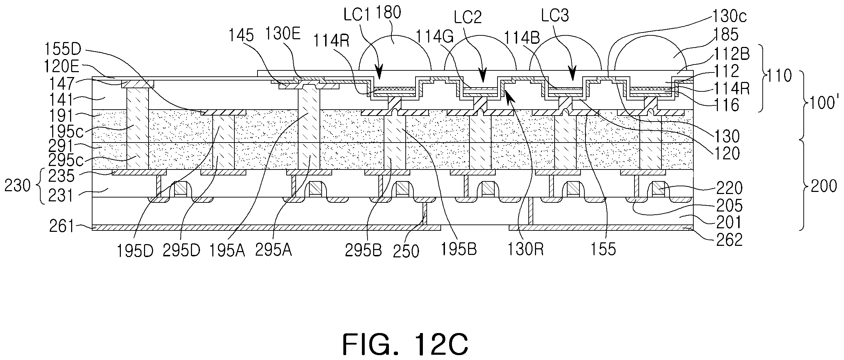

Subsequently, referring to FIG. 12C, a first conductivity-type semiconductor base layer 112B, positioned in a pad region PAD, may be further removed, and microlenses 180 and bonding pads (199 in FIG. 3) may be further formed, thereby manufacturing the display apparatus 10 illustrated in FIG. 3. In one or more embodiments, the microlenses 180 may be formed to have different sizes depending on areas of the LED cells LC1, LC2, and LC3.

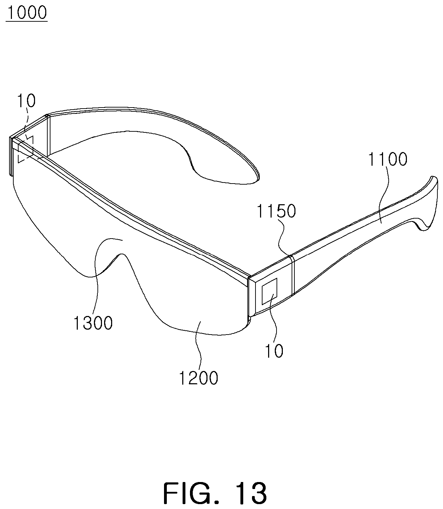

FIG. 13 is a diagram of an electronic device including a display apparatus according to one or more embodiments.

Referring to FIG. 13, an electronic device 1000 according to one or more embodiments may be a glasses-type display, a wearable device. The electronic device 1000 may include a pair of temples 1100, a pair of optical coupling lenses 1200, and a bridge 1300. The electronic device 1000 may further include a display apparatus 10 including an image generator.

The electronic device 1000 may be a head-mounted, glasses-type, or goggle-type virtual reality (VR) device, augmented reality (AR) device, or mixed reality (MR) device capable of providing virtual reality or providing both virtual images and actual external scenery.

Temples 1100 may extend in one direction. The temples 1100 may be spaced apart from each other, and may extend in parallel. The temples 1100 may be folded toward the bridge 1300 using the hinge connector 1150. The bridge 1300 may be provided between the optical coupling lenses 1200 to connect the optical coupling lenses 1200 to each other. The optical coupling lenses 1200 may include a light guide plate. The display apparatus 10 may be disposed on each of portions of the temples 1100 adjacent to the optical coupling lenses 1200, and may generate an image on the optical coupling lenses 1200. In one or more embodiments, the display apparatus 10 may be disposed in portions of the optical coupling lenses 1200.

According to one or more embodiments, LED cells provided as a light source of a subpixel may be designed to have different areas depending on an emission wavelength, thereby reducing a variation in light output depending on the emission wavelength. Microlens may be designed to have different sizes, thereby implementing light emitted from the LED cells having different areas to have an orientation angle that is in a certain range.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A display apparatus comprising:
a circuit board (200) comprising a driving circuit;
a pixel array (100; 100A; 100B) on the circuit board (200) and comprising unit pixels (PX), each of the unit pixels (PX) comprising a plurality of subpixels (SP1, SP2, SP3); and
a plurality of microlenses (180R, 180G, 180B) respectively on the plurality of subpixels (SP1, SP2, SP3),
wherein the pixel array (100; 100A; 100B) further comprises:
a plurality of light-emitting diode, LED, cells (LC1, LC2, LC3) each respectively comprising a first conductivity-type semiconductor layer (112), an active layer (114R, 114G, 114B), and a second conductivity-type semiconductor layer (116) that are sequentially stacked;
a passivation layer (120) on side surfaces and lower surfaces of the plurality of LED cells (LC1, LC2, LC3);
a reflective layer (160) on the passivation layer (120), the reflective layer (160) configured to emit light toward upper surfaces of the plurality of LED cells (LC1, LC2, LC3);
a gap-fill insulating layer (141; 141') on the side surfaces and lower surfaces of the plurality of LED cells (LC1, LC2, LC3), the gap-fill insulating layer (141; 141') at least partially covering the passivation layer (120) and the reflective layer (160);
a first connection electrode (130) on the gap-fill insulating layer (141; 141'), and connected to the first conductivity-type semiconductor layers (112); and
a second connection electrode (155) on the gap-fill insulating layer (141; 141'), and connected to the second conductivity-type semiconductor layers (116),
wherein the plurality of LED cells (LC1, LC2, LC3) comprise a first LED cell (LC1) configured to emit first light, a second LED cell (LC2) configured to emit second light, and a third LED cell (LC3) configured to emit third light,
wherein a width (S1) of the first LED cell (LC1) is greater than a width (S2) of the second LED cell (LC2) and a width (S3) of the third LED cell (LC3),
wherein the plurality of microlenses (180R, 180G, 180B) comprise a first microlens (180R) on the first LED cell (LC1), a second microlens (180G) on the second LED cell (LC2), and a third microlens (180B) on the third LED cell (LC3), and
wherein a width (W1') of the first microlens (180R) is greater than a width (W2') of the second microlens (180G) and a width (W3') of the third microlens (180B).

2. The display apparatus of claim 1, wherein the circuit board (200) further comprises:
a device board (201) on which elements (220) for the driving circuit are provided;
a lower bonding structure (290) comprising a lower bonding insulating layer (291) on the device board (201), and lower bonding electrodes (295) in the lower bonding insulating layer (291), the lower bonding electrodes (295) respectively connected to the elements (220), and
wherein the pixel array (100; 100A; 100B) further comprises:
an upper bonding structure (190) comprising an upper bonding insulating layer (191) on a lower surface of the gap-fill insulating layer (141; 141'), and upper bonding electrodes (195) connected to the first connection electrode (130) and the second connection electrode (155), the upper bonding insulating layer (191) bonded to the lower bonding insulating layer (291), and the upper bonding electrodes (195) respectively bonded to the lower bonding electrodes (295).

3. The display apparatus of claim 1 or 2, wherein the passivation layer (120) comprises a first insulating layer (121) contacting surfaces of the plurality of LED cells (LC1, LC2, LC3), and a second insulating layer (125) on the first insulating layer (121), and
wherein the first insulating layer (121) comprises at least one of ZrO₂, Al₂O₃, and HfO₂.

4. The display apparatus of any one of claims 1 to 3, wherein the pixel array (100; 100A; 100B) further comprises a distributed Bragg reflector, DBR, layer (129) on the passivation layer (120), the DBR layer (129) in which first dielectric layers (129a) and second dielectric layers (129b) having different refractive indices are alternately stacked.

5. The display apparatus of any one of claims 1 to 4, wherein the width of the first LED cell (LC1) is 5 µm or less.

6. The display apparatus of any one of claims 1 to 5, wherein the width of the second LED cell (LC2) is greater than the width of the third LED cell (LC3).

7. The display apparatus of any one of claims 1 to 6, wherein the width of the second microlens (180G) is greater than the width of the third microlens (180B).

8. The display apparatus of any one of claims 1 to 7, wherein the active layers (114R, 114G, 114B) of the plurality of LED cells (LC1, LC2, LC3) comprise a multiple quantum well structure, and
wherein a number of quantum well layers (114b) of the active layer (114R) of the first LED cell (LC1) is greater than a number of quantum well layers (114b') of the active layer (114G) of the second LED cell (LC2) and a number of quantum well layers (114b") of the active layer (114B) of the third LED cell (LC3).

9. The display apparatus of any one of claims 1 to 8, further comprising a first conductivity-type semiconductor base layer (112B) shared by the plurality of LED cells (LC1, LC2, LC3).

10. The display apparatus of claim 9, wherein the first connection electrode (130) is in the gap-fill insulating layer (141; 141'), and is connected to the first conductivity-type semiconductor base layer (112B) between the plurality of LED cells (LC1, LC2, LC3).

11. The display apparatus of any one of claims 1 to 10, wherein the first connection electrode (130) is in a region between the plurality of LED cells (LC1, LC2, LC3) on the pixel array, and is connected to the first conductivity-type semiconductor layer (112) of each of the plurality of LED cells (LC1, LC2, LC3).

12. The display apparatus of any one of claims 1 to 11, wherein, in a plan view, the first connection electrode (130) comprises an electrode extending along a region between the plurality of LED cells (LC1, LC2, LC3).

13. The display apparatus of any one of claims 1 to 12, wherein the second connection electrode (155) is in the gap-fill insulating layer (141; 141'), and is connected to the second conductivity-type semiconductor layer (116) of each of the plurality of LED cells (LC1, LC2, LC3).

14. The display apparatus of any one of claims 1 to 13, wherein the pixel array (100; 100A; 100B) further comprises contact electrodes (152) respectively on the second conductivity-type semiconductor layer (116) of each of the plurality of LED cells (LC1, LC2, LC3).

15. The display apparatus of any one of claims 1 to 14, wherein the reflective layer (160) extends to the side surfaces of the plurality of LED cells (LC1, LC2, LC3).
